# EUROPÄISCHE PATENTSCHRIFT

(11) **EP 1 578 017 B1**
(45) Veröffentlichungstag und Bekanntmachung des Hinweises auf die Patenterteilung: **17.02.2010**
(21) Anmeldenummer: 05005978.1
(22) Anmeldetag: 18.03.2005
(51) Int. Cl.: H03K 17/74

(54) **Elektronischer Schalter für Hochfrequenz-Verbindungen**
Electronic switch for high-frequency connections
Commutateur électronique pour connexions haute fréquence

(30) Priorität: 19.03.2004 DE 102004014027
(43) Veröffentlichungstag der Anmeldung: 21.09.2005
(73) Patentinhaber: Feig Electronic GmbH, 35781 Weilburg-Waldhausen (DE)
(72) Erfinder: Wennrich, Andreas, 65554 Limburg (DE); Eichel, Klaus H., 89264 Weissenhorn (DE)
(74) Vertreter: Knefel, Cordula

(56) Entgegenhaltungen:
- WO-A-2004/023651
- DE-A1- 10 305 361
- DE-C1- 4 422 069
- US-A1- 2003 174 099
- PATENT ABSTRACTS OF JAPAN Bd. 1999, Nr. 04, 30. April 1999 (1999-04-30) & JP 11 004151 A (SHOWA ELECTRIC WIRE & CABLE CO LTD), 6. Januar 1999 (1999-01-06)

## Beschreibung

Die Erfindung betrifft einen elektronischen Schalter zum Öffnen und Schließen einer Hochfrequenz-Verbindung ab 1 Megahertz (1 MHz).

Das Sachgebiet der Erfindung betrifft einen elektronischen Schalter, der Leistungen von beispielsweise 15 Watt (W) bei Spannungen von 500 Volt (V) und Strömen von 2 Ampere (A) schalten kann. Diese elektrischen Größen können zum Beispiel an den Antennen einer Schreib-/Lesestation eines Long-Range RFID-Systems auftreten, wenn diese für die Kommunikation mit passiven Transpondern ausgelegt werden, bei denen der Abstand zwischen den Transpondern und der Anntenne des RFID-Systems eine Distanz von 0,5 Meter überschreiten.

Eine Anforderung an einen solchen Schalter für Hochfrequenz-Verbindungen ist es, einen Hochfrequenz-Strom bis zu 2 A unter Last schalten zu können. Das heißt, der Schalter muss einen sehr kleinen Widerstand kleiner als 1 Ohm (Ω) für die Hochfrequenz darstellen.

Eine weitere Anforderung besteht darin, dass die Stromaufnahme beim Schalten beziehungsweise im stationären Zustand des Schalters möglichst klein (< 250 mA) sein soll.

Eine weitere Anforderung besteht darin, dass Schaltvorgänge sehr schnell erfolgen müssen, das heißt, die Schaltzeit muss kleiner 1 Millisekunde (ms) sein.

Eine Anforderung ist eine hohe Lebensdauer und eine hohe Anzahl möglicher Schaltspiele. Es ist erforderlich, dass die maximale Anzahl von Schaltspielen größer 15 Milliarden beträgt, damit der Schalter bei einer Schaltfrequenz von beispielsweise 50 Hz eine Lebensdauer von mindestens 10 Jahren erreicht.

Zudem müssen derartige Hochfrequenz-Schalter das Spektrum des zu schaltenden Hochfrequenz-Signals so gut wie nicht verändern, damit so gut wie keine Oberwellen entstehen.

Eine weitere Anforderung besteht darin, dass der Schalter Platz sparend und kostengünstig realisiert werden muss.

Zudem besteht die Anforderung, mit einem derartigen Hochfrequenz-Schalter Wechselspannungen mit einem Spitzenwert von Us von 500 V beziehungsweise einen Spitze-Spitze-Wert Uss von 1000 V schalten zu können.

Diese Spannungen ergeben sich beispielsweise an der Antenne einer Schreib-/Lesestation eines RFID-Systems, wenn das RFID-System für die Kommunikation mit passiven Transpondern ausgelegt ist, und bei denen der Abstand zwischen den Transpondern und der Anntenne des RFID-Systems einen Abstand von 0,5 Metern überschreiten kann. Das Funktionsprinzip eines derartigen RFID-Systems beruht auf der induktiven Kopplung zwischen der Antenne der Schreib-/Lesestation und der Antenne der passiven Transponder, wobei die Transponder über den Weg der induktiven Kopplung von der Schreib-/Lesestation mit elektrischer Energie versorgt werden. Bei derartigen RFID-Systemen, die häufig mit einer Frequenz von 13,56 Megahertz (MHz) betrieben werden, haben sich Antennen mit einer Induktivität von rund 2 Mikro-Hennry (µH) und einer Güte (Q) von 45 als vorteilhaft erwiesen. Die Antenne des RFID-Systems arbeitet dabei jeweils in einem Bereich der Resonanz, wodurch hohe Ströme und/oder Spannungen entstehen, die vom erfindungsgemäßen Schalter geschaltet werden können.

Eine weitere Anforderung an den erfindungemäßen Hochfrequenz-Schalter ist, dass das Steuersignal zur Steuerung des Schalters über dieselbe Leitungsverbindung zum Schalter geführt werden kann wie das zu schaltende Hochfrequenz-Signal.

Die bekannten Verfahren zum Schalten eines Hochfrequenz-Signals wie Relais, FET-Schalter, bekannte PIN-Diodenschalter oder Optokoppler können nicht allen oben genannten Anforderungen gerecht werden.

Die Probleme beim Einsatz von Relais oder Reed-Relais bestehen darin, dass sie entweder den hohen Antennenstrom nicht dauerhaft führen können, zu lange Schaltzeiten (größer 1ms besitzen) oder zu groß sind. Auf jeden Fall können sie die lange Lebensdauer, das heißt die Anzahl der geforderten Schaltspiele nicht erreichen. Bekannte Relais mit geringen Schaltzeiten (≥1 ms) erreichen bis maximal 1 Milliarde Schaltzyklen.

Schalter aus Feldeffekttransistoren oder Bipolartransistoren haben zu hohe Kapazitäten, was dazu führt, dass sie schon bei 1 MHz im abgeschalteten Zustand einen zu niedrigen Widerstand besitzen und so die Hochfrequenz-Verbindung nicht oder nur unvollständig trennen. Dieser negative Effekt wird durch höhere Frequenzen noch verstärkt. Transistoren mit sehr niedrigen Kapazitäten können nicht für Ströme bis 2A eingesetzt werden. Optokoppler haben die gleichen negativen Eigenschaften, da sie am Ausgang Transistoren schalten.

Bei preiswerten bekannten PIN-Diodenschaltern besteht das Problem, dass sehr viele PIN-Dioden parallel geschaltet werden müssen, um Ströme bis 2A schalten zu können. Dazu ist allerdings ein hoher Steuerstrom größer als 200 mA zum Durchschalten der Dioden erforderlich. Des weiteren muss die anliegende Steuerspannung mit geeigneten Bauteilen am PIN-Diodenschalter hochfrequenzseitig entkoppelt werden, um die zu schaltende Hochfrequenz nicht über die Quelle der Steuerspannung kurzzuschließen.

Zum Stand der Technik (Patent Abstracts of Japan, Bd. 1999, Nr. 04, 30. April 1999 & JP11004151 A (SHOWA ELECTRIC WIRE & CABLE CO LTD), 6. Januar 1999) gehört ein PIN-Diodenschalter, der dazu dient, ein Hochfrequenzsignal zwischen Punkten T1 und T2 aufzutrennen. Hierzu sind jeweils zwei PIN-Dioden (PD1 + PD2, PD3 + PD4, PD5 + PD6) in Reihe angeordnet. Drei dieser in Reihe geschalteten PIN-Dioden sind antiparallel angeordnet.

Dieser zum Stand der Technik gehörende FIN-Diodenschalter weist vier Diodenschalteranschlüsse auf. Das HF-Signal wird zwischen den Punkten T1 und T2 eingespeist. Der Gleichstrom zur Steuerung des PIN-Diodenschalters fließt über eine separate Leitungsverbindung von +B über R1, CC1 über die PIN-Dioden PD1, PD2, PD3, PD4, PD5, PD6 und fließt über die separate Verbindung über CC2 und R2 gegen Ground ab.

Dieser zum Stand der Technik gehörende PIN-Diodenschalter weist damit die Nachteile auf, dass zwei Hin- und zwei Rückleitungen und damit vier Diodenschalteranschlüsse erforderlich sind.

Das der Erfindung zu Grunde liegende technische Problem besteht darin, einen Schalter so aufzubauen, dass die oben beschriebenen Anforderungen erfüllt werden.

Dieses technische Problem wird durch einen elektronischen Schalter mit den Merkmalen gemäß Anspruch 1 gelöst.

Die technische Lösung für einen elektronischen Schalter für Hochfrequenz-Verbindungen ab 1 Megahertz, die hier beschrieben wird, besteht darin, mindestens zwei PIN-Dioden mit weiteren Bauteilen so zu schalten, dass die PIN-Dioden gleichstrommäßig in Reihe und wechselstrommäßig antiparallel geschaltet sind, und bei dem der Schalter lediglich zwei PIN-Diodenschalteranschlüsse aufweist, und bei dem für die Zuführung der Gleichspannung zum Schalter zur Steuerung des elektronischen Schalters und für das zu schaltende Hochfrequenzsignal eine elektrische Verbindung vorgesehen ist, die für die Gleichspannung und für das zu schaltende Hochfrequenzsignal dieselbe Leitungsverbindung ist. Durch diese Schaltung kann bei gleichem Steuerstrom doppelt so viel Hochfrequenzstrom geschaltet werden wie beim Einsatz von nur einer PIN-Diode. Dadurch können preiswertere PIN-Dioden eingesetzt werden.

Ferner wird durch die Anordnung von Impedanzen innerhalb des PIN-Diodenschalters erreicht, dass das zu schaltende Hochfrequenzsignal und der Steuerstrom zur Steuerung der PIN-Dioden über dieselbe Leitung geführt werden kann, womit eine zusätzlich Leitungsverbindung zur Steuerung des erfindungsgemäßen PIN-Diodenschalters überflüssig ist.

In einer weiteren vorteilhaften Ausführungsform wird die Schaltung symmetrisch aufgebaut. Durch die antiparallele Anordnung der PIN-Dioden und die symmetrische Schaltungsform werden die Nichtlinearitäten der PIN-Dioden kompensiert, so dass Oberwellen erheblich reduziert werden.

Eine weitere vorteilhafte Schaltungsform sieht vor, den Gleichspannungspfad im abgeschalteten Zustand so aufzutrennen, dass sich zwischen Anode und Kathode der PIN-Dioden jeweils die negative Spannung zum Sperren der PIN-Dioden aufbauen kann. Somit ist keine zusätzliche Sperrspannung zum Öffnen des Schalters erforderlich.

In einer vorteilhaften Schaltungsform wird die Steuerspannung an der Hochfrequenz-Masse eingespeist. Damit sind keine zusätzlichen Bauteile zum Entkoppeln der Hochfrequenz von der Gleichspannungsquelle (Steuerspannung) erforderlich. Ferner hat die Einspeisung der Steuerspannung am Hochfrequenz-Massepunkt den großen Vorteil, dass die Bauteile zur Entkopplung der Steuerspannung von der Hochfrequenz nur eine geringe Spannungsfestigkeit benötigen und somit preiswert sind.

Ein Einsatzgebiet des erfindungsgemäßen Schalters ist beispielsweise in der RFID-Technik zu finden. Dort muss beispielsweise die Trägerfrequenz von 13,56 Megahertz von einer Antenne zu einer anderen Antenne umgeschaltet werden, was mit so genannten Multiplexern erfolgen kann, oder es müssen Antennen, die sich gegenseitig über elektromagnetische Felder beeinflussen, so verändert werden, dass der Einfluss aufeinander möglichst gering wird beziehungsweise die Beeinflussung der Antennen untereinander durch Einsatz einer so genannten Abgleichschaltung kompensiert wird. Eine effektive Art zur Vermeidung einer gegenseitigen Beeinflussung von Antennen ist das Auftrennen der Antennenwindung durch einen Schalter, der die oben beschriebenen Anforderungen erfüllt.

Die oben genannten Vorteile und Merkmale werden an Ausführungsbeispielen erfindungsgemäßer Schalter in den zugehörigen Zeichnungen beispielhaft dargestellt. Dabei zeigen:
- Fig. 1: ein Schaltbild des Schaltungsprinzips mit zwei PIN-Dioden;
- Fig. 2: ein Schaltbild mit symmetrischem Aufbau des Schalters;
- Fig. 3: ein Schaltbild eines Anwendungsbeispiels mit einer Antennenanpassung und Einspeisung der Steuerspannung an Hochfrequenz-Masse.

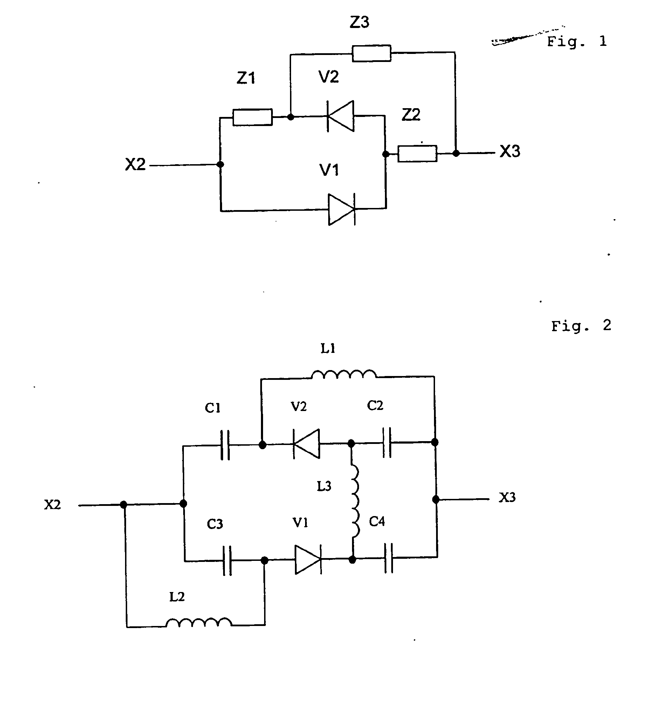

Fig. 1 zeigt den prinzipiellen Aufbau eines PIN-Diodenschalters, bestehend aus zwei PIN-Dioden (V1, V2) und den Impedanzen (Z1, Z2, Z3). Die PIN-Dioden (V1, V2) sind wechselstrommäßig über die Impedanz (Z1) antiparallel geschaltet. Die Impedanzen (Z1, Z2) sind dabei so dimensioniert, dass sie bei der zu schaltenden Frequenz einen sehr kleinen Widerstand ergeben, für Gleichspannung aber sehr hochohmig sind. Die Impedanz (Z3) ist so dimensioniert, dass sie für die zu schaltende Frequenz einen sehr hohen Widerstand darstellt, für die Gleichspannung aber niederohmig ist. Gleichstrommäßig sind die beiden PIN-Dioden (V1, V2) in Reihe geschaltet. Der Steuerstrom, der ein Gleichstrom ist, fließt vom PIN-Diodenschalteranschluss (X2) über die PIN-Diode (V1), die PIN-Diode (V2) und über die Impedanz (Z3) zum PIN-Diodenschalteranschluss (X3).

Fließt ein entsprechender Steuerstrom durch die PIN-Dioden (V1, V2), so sind diese auch für beide Halbwellen der zu schaltenden Hochfrequenz leitend. In diesem Zustand kann das zu schaltende Hochfrequenzsignal über die PIN-Diode (V1) und über die parallel dazu angeordnete Reihenschaltung aus der Impedanz (Z1) und der PIN-Diode (V2) sowie über die zu dieser Parallelschaltung in Reihe liegenden Impedanz (Z2) zwischen den PIN-Diodenschalteranschlüssen (X2 und X3) fließen.

Liegt eine negative Spannung in Höhe der negativen Halbwelle des zu schaltenden Hochfrequenzsignals an, so sind die PIN-Dioden (V1, V2) nichtleitend.

Fig. 2 zeigt eine Modifizierung der Schaltung aus Fig. 1. Die Impedanzen (Z1, Z2) sind als Kondensatoren (C1, C2) ausgeführt, die Impedanz (Z3) wird durch eine Spule (L1) realisiert. Zusätzliche Kondensatoren (C3, C4) sowie Spulen (L2, L3) sorgen dafür, dass der Schalter wechselstrommäßig symmetrisch aufgebaut ist. Der zu schaltende hochfrequente Wechselstrom ist somit in den PIN-Dioden (V1, V2) nahezu gleich. Die Verzerrungen, die durch die Nichtlinearitäten erzeugt werden, werden dadurch kompensiert und die Oberwellen erheblich reduziert.

Zum Schließen des PIN-Diodenschalters fließt ein Steuerstrom, der ein Gleichstrom ist, von dem PIN-Diodenschalteranschluss (X2) über die Induktivität (L2), die PIN-Diode (V1), die Induktivität (L3), die PIN-Diode (V2) und die Induktivität (L1) zum PIN-Diodenschalteranschluss (X3).

Das zu schaltende Hochfrequenzsignal fließt im geschlossenen Zustand des PIN-Diodenschalters vom PIN-Diodenschalteranschluss (X2) über den Zweig, bestehend aus der Kapazität (C1), PIN-Diode (V2) und Kapazität (C2), und den dazu parallel angeordneten Zweig, bestehend aus der Kapazität (C3), PIN-Diode (V1) und Kapazität (C4), zum PIN-Diodenschalteranschluss (X3).

Zum Öffnen des PIN-Diodenschalters wird eine negative Steuerspannung, die eine Gleichspannung ist, über den PIN-Dioden (V1) und (V2) benötigt. Im Falle der PIN-Diode (V2) bildet sich diese negative Gleichspannung mit Hilfe des anliegenden Hochfrequenzsignals und den Kapazitäten (C1) und (C2) und der Diode (V2) selbstständig aus. Im Falle der PIN-Diode (V1) wird die Ausbildung der negativen Gleichspannung über der PIN-Diode (V1) durch die parallel zur Kapazität (C3) liegende Induktivität (L2) verhindert, weshalb zum Öffnen des PIN-Diodenschalters eine Gleichspannung am Diodenschalteranschluss (X2) benötigt wird, die gegenüber dem Diodenschalteranschluss (X3) negativ sein muss.

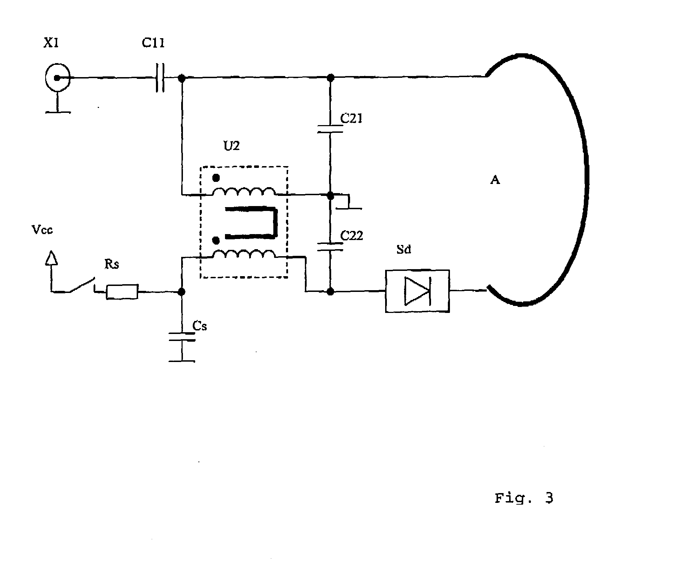

Fig. 3 zeigt eine Anwendung des erfindungsgemäßen Schalters, bei dem die Steuerspannung am Massepunkt der Hochfrequenz eingespeist ist. Die Schaltung stellt eine Einrichtung zum Einstellen von induktiven Antennen im 13,56 MHz-Band dar, bei der die Antennenwindung (A) durch den erfindungsgemäßen Schalter auftrennbar ist. Die Kondensatoren (C11, C21, C22) werden zum Einstellen der Impedanz der Antennenanordnung verwendet. Ein Übertrager (U2) bewirkt eine Symmetrierung der Antenne (Symmetrierglied) wie dies in der Nachrichtentechnik üblich und notwendig ist, um das unsymmetrische Anschlusskabel der Antenne an die symmetrische Antenne anzuschließen. Das Symmetrierglied kann in anderen Ausführungsformen, beispielsweise auch aus Kombinationen aus Induktivitäten und Kondensatoren aufgebaut sein. Ein Kondensator (Cs) ist so dimensioniert, dass er für die Hochfrequenz nahezu einen Kurzschluss darstellt. Ein Schalter (Sd) ist der erfindungsgemäße PIN-Diodenschalter. Über einen Widerstand (Rs) wird die Höhe des Gleichstroms zum Steuern des PIN-Diodenschalters bestimmt.

Durch die so aufgebaute Schaltung kann auf große und teure Induktivitäten mit hoher Spannungsfestigkeit verzichtet werden. Zudem ist das bereits vorhandene Symmetrierglied (U2) so in die Schaltung einbezogen, dass keine zusätzlichen Induktivitäten zum Betrieb des PIN-Diodenschalters benötigt werden.

Wie Fig. 4 ferner zeigt, liegt der HF-Symmetriepunkt (Massepunkt) der Antenne zwischen den Kondensatoren (C21 und C22). Gleichzeitig liegt ein Anschluss des Kondensators (Cs) ebenfalls auf dem Symmetriepunkt (Massepunkt) und ist so dimensioniert, dass er für einen HF-Strom nahezu einen Kurzschluss bildet, so dass er einen HF-Strom praktisch ungehindert durchleitet, während er für eine Gleichspannung einen sehr hohen Widerstand darstellt, so dass über ihn praktisch kein Gleichstrom fließen kann. Hierdurch wird es möglich, über den Widerstand (Rs) eine Gleichspannung zur Steuerung des PIN-Diodenschalters (Sd) einzuspeisen, die damit am HF-Symmetriepunkt zwischen (C21 und C22) ihr Massepotential hat.

Über die erste Induktivität des Symmetriergliedes (U2) kann die Gleichspannung zum PIN-Diodenschalter (Sd) und von dort über die Antennenschleife und die zweite Induktivität des Übertragers (U2) gegen Masse fließen und so zur Steuerung des PIN-Diodenschalters eingesetzt werden.

### Bezugszahlen

- A: Antennenwindung
- C1: Kondensator
- C11: Kondensator
- C2: Kondensator
- C21: Kondensator
- C22: Kondensator
- C3: Kondensator
- C4: Kondensator
- Cs: Kondensator
- L1: Spule
- L2: Spule
- L3: Spule
- Rs: Widerstand
- Sd: PIN-Diodenschalter
- U2: Übertrager (Symmetrierglied)
- V1: PIN-Diode
- V2: PIN-Diode
- X1: Antennenanschluss
- X2: PIN-Diodenschalteranschluss
- X3: PIN-Diodenschalteranschluss
- Z1: Impedanz
- Z2: Impedanz
- Z3: Impedanz

## Patentansprüche

1. Elektronischer Schalter zum Schalten von Hochfrequenz ab 1 Megahertz, bestehend aus mindestens zwei PIN-Dioden (V1, V2), die durch eine Gleichspannung steuerbar sind, wobei
- die PIN-Dioden (V1, V2) gleichstrommäßig in Reihe geschaltet sind, und
- die PIN-Dioden (V1, V2) wechselstrommäßig antiparallel geschaltet sind,
**dadurch gekennzeichnet,**
- **dass** der Schalter (Sd) lediglich zwei PIN-Diodenschalteranschlüsse (X2, X3) aufweist, und
- **dass** für die Zuführung der Gleichspannung zur Steuerung des elektronischen Schalters (Sd) zum Schalter (Sd) und für das zu schaltende Hochfrequenzsignal eine elektrische Verbindung vorgesehen ist, die für die Gleichspannung und für das zu schaltende Hochfrequenzsignal dieselbe Leitungsverbindung ist.

2. Schalter nach Anspruch 1, **dadurch gekennzeichnet, dass** der Schalter (Sd) mit Bauteilen (V1, V2, C1, C2, C3, C4, L1, L2, L3) wechselstrommäßig symmetrisch aufgebaut ist.

3. Antennenwindung (A) mit einem Schalter nach einem der Ansprüche. 1 oder 2, wobei der Schalter (Sd) zum Trennen der Antennenwindung (A) in die Antennenwindung (A) integriert ist.

4. Anpassschaltung zum Einstellen von induktiven Antennen im 13,56-MHz-Band, **dadurch gekennzeichnet, dass** ein Schalter (Sd) mit den Merkmalen gemäß Anspruch 1 oder 2 zum Auftrennen einer Antennenwindung (A) vorgesehen ist.

5. Anpassschaltung nach Anspruch 4, **dadurch gekennzeichnet, dass** eine Steuerspannung am Massepunkt der Hochfrequenz eingespeist ist.

## Claims

1. An electronic switch for switching high frequency from 1 megahertz, comprising at least two PIN diodes (V1, V2) which are controllable by a direct-current voltage, wherein
- the PIN diodes (V1, V2) are connected in series in terms of direct current, and
- the PIN diodes (V1, V2) are connected in an antiparallel manner in terms of alternating current,
**characterized in that**
- the switch (Sd) has only two PIN-diode switch terminals (X2, X3), and
- an electrical connexion, which is the same line connexion for the d.c. voltage - for controlling the electronic switch (Sd) - and for the high-frequency signal to be switched, is provided for supplying the d.c. voltage to the switch (Sd) and is provided for the high-frequency signal to be switched.

2. A switch according to Claim 1, **characterized in that** the switch (Sd) is designed in a symmetrical manner in terms of alternating current with components (V1, V2, C1, C2, C3, C4, L1, L2, L3).

3. An aerial winding (A) with a switch according to one of Claims 1 or 2, wherein the switch (Sd) for separating the aerial winding (A) is integrated in the aerial winding (A).

4. A matching circuit for setting inductive aerials in the 13·56 MHz band, **characterized in that** a switch (Sd) with the features according to Claim 1 or 2 for separating an aerial winding (A) is provided.

5. A matching circuit according to Claim 4, **characterized in that** a control voltage is fed in at the earth point of high frequency.

## Revendications

1. Commutateur électronique pour des commutations à haute fréquence à partir de 1 mégahertz, constitué d'au moins deux diodes PIN (V1, V2) qui peuvent être commandées par une tension continue,
- les diodes PIN (V1, V2) étant connectées en série lorsqu'elles sont alimentées en courant continu, et
- les diodes PIN (V1, V2) étant connectées de façon antiparallèle lorsqu'elles sont alimentées en courant alternatif,
**caractérisé en ce que**
- le commutateur (Sd) ne présente que deux bornes (X2, X3) de connexion de diodes PIN, et
- une liaison électrique est prévue pour l'alimentation en tension continue du commutateur (Sd) pour la commande du commutateur électrique (Sd) et pour le signal à haute fréquence à commuter, ladite liaison électrique étant la même liaison pour la tension continue et pour le signal à haute fréquence à commuter.

2. Commutateur selon la revendication 1, **caractérisé en ce que** le commutateur (Sd) est monté avec des composants (V1, V2, C1, C2, C3, C4, L1, L2, L3) de façon symétrique en alimentation par courant alternatif.

3. Spire d'antenne (A) avec un commutateur selon l'une des revendications 1 ou 2, dans laquelle le commutateur (Sd) est intégré dans la spire d'antenne pour la séparation de la spire d'antenne (A).

4. Circuit d'adaptation pour le réglage d'antennes inductives dans la bande 13,56 MHz, **caractérisé en ce qu'**un commutateur (Sd) ayant les caractéristiques selon la revendication 1 ou 2 est prévu pour 1a coupure d'une spire d'antenne (A).

5. Circuit d'adaptation selon la revendication 4, **caractérisé en ce qu'**une tension de commande est fournie à la masse de la haute fréquence.
